(19) Europäisches Patentamt
European Patent Office
Office européen des brevets

(11) **EP 2 417 280 B1**

(12) **FASCICULE DE BREVET EUROPEEN**

(45) Date de publication et mention
de la délivrance du brevet:
**06.11.2013   Bulletin 2013/45**

(21) Numéro de dépôt: **10723660.6**

(22) Date de dépôt: **12.04.2010**

(51) Int Cl.:
**B22F 3/115** *(2006.01)*       **B22F 7/08** *(2006.01)*
**C23C 4/10** *(2006.01)*        **H01J 37/34** *(2006.01)*
**C23C 4/08** *(2006.01)*        **C23C 4/12** *(2006.01)*
**C23C 14/34** *(2006.01)*       **H01L 31/0224** *(2006.01)*

(86) Numéro de dépôt international:
**PCT/FR2010/050704**

(87) Numéro de publication internationale:
**WO 2010/116112 (14.10.2010 Gazette 2010/41)**

(54) **PROCÉDÉ D'ÉLABORATION D'UNE CIBLE PAR PROJECTION THERMIQUE**

**HERSTELLUNGSVERFAHREN EINES ZIELS MIT THERMISCHER PROJEKTION EINES ZIELS**

**PRODUCTION METHOD OF A TARGET WITH THERMAL PROJECTION**

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité:  **10.04.2009   FR 0952394**

(43) Date de publication de la demande:
**15.02.2012   Bulletin 2012/07**

(73) Titulaire: **Saint-Gobain Coating Solutions
84093 Avignon Cedex 9 (FR)**

(72) Inventeur: **BILLIERES, Dominique
F-84450 Saint-Saturnin Les Avignon (FR)**

(74) Mandataire: **Neuviale, Bertrand
SAINT-GOBAIN RECHERCHE
Département Propriété Industrielle
39 Quai Lucien Lefranc
93300 Aubervilliers (FR)**

(56) Documents cités:
**EP-A1- 0 479 678         EP-A1- 1 626 416
EP-A1- 1 712 962         EP-B1- 1 090 158
US-A1- 2006 233 965      US-A1- 2008 138 620
US-A1- 2008 271 779**

• **MURAKAMI K ET AL: "Rapidly solidified thick
deposit layers of Fe-C-Mo alloys by flame
spraying", MATERIALS SCIENCE AND
ENGINEERING A: STRUCTURAL MATERIALS:
PROPERTIES, MICROSTRUCTURE &
PROCESSING, LAUSANNE, CH, vol. A117, 1
janvier 1989 (1989-01-01), pages 227-233,
XP002082154, ISSN: 0921-5093**
• **MULLER M ET AL: "Radio frequency plasma
processing to produce chromium sputter
targets", INSPEC, 1 décembre 2000 (2000-12-01),
XP008114705,**

**Description**

La présente invention concerne un procédé d'élaboration d'une cible destinée à être utilisée dans les procédés de dépôt sous vide, en atmosphère neutre ou réactive, notamment par pulvérisation cathodique assistée par champ magnétique, par pulvérisation ou par source d'ions.

On connaît diverses techniques conduisant à la fabrication de cibles dont certaines à partir de la mise en forme de poudres. Ainsi, les cibles en question peuvent résulter d'un processus de fonderie (dans le cas de cibles métalliques), de frittage de poudres suivi de techniques de mise en forme (dans le cas de cibles métalliques), souvent à chaud puis d'assemblage sur un support, ou directement d'assemblage de segments frittés, ou moins classiquement d'une technique de projection thermique, et plus particulièrement d'une technique de projection par torche plasma (ou communément appelée plasma spray en anglais).

Ces cibles sont destinées à être mises en oeuvre au sein de procédés couramment employés à l'échelle industrielle pour le dépôt de couches minces, notamment sur substrat verrier, comme par exemple le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée.

Dans le cas spécifique d'une cible destinée au dépôt de molybdène, on utilise un procédé de dépôt dit « non-réactif » où le plasma est composé uniquement d'un gaz assurant la pulvérisation, préférentiellement un gaz noble de type Ar, Kr, Xe ou Ne. Ce procédé est mis en oeuvre pour des substrats de grande dimension et peut permettre le dépôt de couches minces sur des substrats, par exemple des feuilles de verre plat, de plus de 6 m de côté.

Ces cibles sont de géométrie plane ou tubulaire.

Les cibles planes offrent l'avantage de pouvoir être intégrées dans des cathodes d'architecture relativement simple par rapport aux cathodes dédiées aux cibles rotatives qui sont beaucoup plus complexes, par contre les cibles planes ont un taux d'utilisation qui est généralement inférieur ou égal à 50 %, ce qui n'est pas le cas des cibles rotatives qui ont un taux d'utilisation nettement supérieur à 50 %.

Dans le cas spécifique des couches minces en métal réfractaire comme par exemple le tungstène ou le molybdène, ce dernier étant un métal particulièrement onéreux, on utilise préférentiellement des cibles rotatives, de géométrie cylindrique, tel que décrit dans le brevet US4356073 car ces cibles présentent un rendement matière (qui représente la proportion de matière pulvérisée par rapport à la quantité de matière disponible sur la cible pour réaliser une couche mince) supérieur à 70%, préférentiellement supérieur à 75%. Néanmoins, on connait aussi d'autres géométries variées de cibles magnétron : planes (disques, carrées, rectangulaires) et l'invention est applicable également à d'autres géométries que le cylindre.

En outre, il existe également d'autres procédés de dépôt sous vide alternatifs à la pulvérisation magnétron et utilisant une cible : il s'agit de la pulvérisation par laser (pulsé ou non : ablation laser), de la pulvérisation par faisceau d'ions par exemple. Ces procédés peuvent également tirer avantage de l'utilisation d'une cible selon l'invention.

Concernant plus particulièrement les cibles magnétrons en molybdène ou autres métaux réfractaires, de nombreuses inventions ont été déposées, portant sur les procédés suivants et faisant l'objet des demandes de brevet énumérées ci-dessous :

- Demandes EP1784518 - US20080193798 -WO2006/041730 :

  Pressage puis frittage d'un lingot ou d'une préforme (sous une pression de 200 à 250 MPa et à une température de 1780 à 2175 °C) puis mise en forme à chaud (environ 900 °C) de cette préforme par laminage ou extrusion, ou forgeage. Généralement ce procédé comprend également un traitement thermique sous hydrogène ou atmosphère réductrice pour réduction du taux d'oxyde dans la cible, ainsi qu'éventuellement un recuit de relaxation de contraintes

- On connaît par ailleurs par la demande W020061171451 a construction de tout ou partie, ou la restauration de cibles par projection de type « cold spray », qui consiste en la projection d'un mélange gaz + poudre porté à vitesse supersonique, la poudre n'étant pas portée à un état de fusion, ce qui diffère des procédés de projection thermique.

Par ailleurs, EP1712962 décrit l'utilisation de jets cryogénique dirigés vers un substrat lors d'un dépôt par projection thermique.

Dans le cas spécifiques des couches minces à base d'oxyde résistif, ces dernières sont généralement obtenues à partir de la pulvérisation magnétron réactive de cibles métalliques et en réalisant l'oxydation du matériau in-situ par la pression partielle d'oxygène introduit dans la chambre de dépôt ou à partir de la pulvérisation en mode RF d'une cible métallique ou céramique.

En effet, le procédé de pulvérisation magnétron DC (courant continu) suppose que le matériau de la cible permette l'évacuation des charges électriques à sa surface. Ceci exclu habituellement les cibles céramiques de compositions résistives.

L'invention permet de réaliser des cibles magnétron à base d'oxydes dits résistifs, avec l'avantage de réduire fortement leur résistivité par l'introduction de lacunes d'oxygène de manière à permettre une utilisation de la cible en mode de pulvérisation DC (courant continu) et non réactif.

La pulvérisation en mode DC (courant continu) non réactif devient alors possible et permet les avantages suivants :

- procédé plus stable (pas d'hystérésis en pression d'oxygène, pas d'instabilité liée à la formation d'un film résistif en surface de la cible initialement conductrice, source d'arcs parasites)
- vitesses de pulvérisations plus élevées (typiquement multipliées par un facteur 1.3 à 3 selon les cas) rendues possibles par le mode magnétron DC non réactif.

De telles cibles peuvent être réalisables, pour certaines compositions par frittage sous atmosphère réductrice. L'invention permet de réaliser de telles cibles avec en plus les avantages liés à l'élaboration par projection plasma à savoir :

- possibilité de réaliser des cibles cylindriques de grandes dimensions monolithiques
- possibilité sur ces cibles de réaliser des surépaisseurs locales aux extrémités (« Dog-Bones »)
- excellente liaison au tube support sans phase intermédiaire fusible ce qui permet l'utilisation des cibles sous de plus fortes puissances, donc des vitesses de déposition de couche mince plus élevées.

Dans le cas spécifiques des couches minces à base d'oxyde résistif, ces dernières sont généralement obtenues à partir de la pulvérisation de cibles élaborées à partir d'un procédé de frittage. La pièce monolithique frittée est ensuite destinée à être brasée sur un support de cible dans le cas de cibles de petites dimensions, ou frittage de segments ou tuiles lesquels seront ensuite juxtaposés lors de l'opération de liaison sur le support de cible dans le cas de cibles de grandes tailles (conduisant alors à des cibles avec joints).

La voie de la projection thermique (notamment de projection plasma), utilisée pour de l'AZO (on pourra se reporter à JP701433 et/ou JP7026373) et/ou à US20070137999 pour des fabrications à base d'ITO, comporte dans le cas de ces matériaux, le handicap de présenter de faibles rendements matière par le fait que la vaporisation du matériau projeté se traduit directement en pertes matières.

Le procédé objet de l'invention permet de :

- minimiser ces pertes et de rendre le procédé viable pour ces compositions
- réduire les contraintes internes dans les cibles élaborées par le procédé en question, sans nécessité d'augmenter la porosité, ce qui permet de construire des cibles ayant des épaisseurs plus importantes que l'état de l'art par projection plasma (par exemple 6 mm pour AZO).

La présente invention s'intéresse à un procédé de réalisation d'une cible à base d'un composé choisi notamment parmi des métaux réfractaires, ou d'oxydes résistifs, ou d'oxydes volatils, par plasma spray offrant des performances en utilisation au moins égales, voire supérieures à celles obtenues par des procédés de fabrication traditionnelle.

Au sens de l'invention, on entend par « oxydes résistifs » la famille d'oxyde dont la résistivité volumique est supérieure à $10^5 \Omega$.cm à 25°C, oxydes parmi lesquels on peut citer les familles suivantes :

a) Oxydes à structure de type Pérovskite de formule de type $ABO_3$ où A et B sont des éléments ou des assemblages d'éléments tels que la somme des valences du ou des éléments constituant A et de la valence du ou des éléments constituant B soit égale à 6. On peut lister les familles d'éléments suivants qui constitueraient A et B :

■ Valence de 1 (K, Rb, ...) associé à un élément de valence 5 (Nb, Ta, V, ..)
■ Valence de 2 (Sr, Ba, Pb, ...) associé à un élément de valence 4 (Ti, Zr, Hf, Sn, Ge, Ce, )
■ Valence de 3 (La, Y, Sc, Bi, ...)

A titre d'exemple, on trouve dans cette famille les oxydes suivants :

- Titanates tels que $BaTiO_3$, $SrTiO_3$, $Pb(Zr_{53}Ti_{47})O_3$ . Le $BaTiO_3$ présente une résisitivité volumique de l'ordre de $10^9$ $\Omega$.cm à température ambiante.
- Niobates tels que PMN $(Pb(Mg_{1/3}Nb_{2/3})O_3)$,

b) Oxydes à structure de type Columbite/Trirutile de type $AB_2O_6$ : où B est Nb ou Ta et A est un élément de valence 2 (Sr, Ba, Pb, ...) ou un assortiment de ces éléments.
A titre d'exemple, on peut citer le Niobate SBN (Sr,Ba)$NbO_6$

c) Oxydes réfractaires et résistifs :

D'autres oxydes tels que $Ta_2O_5$, $Nb_2O_5$, $V_2O_5$, $ZrO_2$, $HfO_2$, $CeO_2$, $Y_2O_3$, $Al_2O_3$, $La_2O_3$, MgO, BeO, ... présentent également une forte résistivité volumique à température ambiante, supérieure à $10^{-5}\Omega$.cm à 25°C.
Des composés mixtes de ces oxydes sont également concernés tels que :

- les solutions solides ($Ta_2O_5$-$Nb_2O_5$),
- les composés ($Al_2O_3$-$Y_2O_3$), YAG par exemple, $LaAlO_3$ (Aluminate de lanthane), ..
- composés de type $D_xT_yO_z$ où D = Zr, Hf, Ce, Ti et où T= Al, Y, La, par exemple Titanate de Lanthane (LaTiOx)
- composés $D_xT_yV_vO_z$ où D = Zr, Hf, Ce, où T= Al, Y, et où V = Ta, Nb, ou V, par exemple (ZrAlNb)Ox

Au sens de l'invention, on entend par « oxydes volatils » la famille d'oxydes dont les températures de début de vaporisation Tvap et de fusion Tf répondent au critère suivant :

$$Tvap < Tf + 400\ °C$$

Parmi ces oxydes, on peut citer les oxydes purs suivants, avec les valeurs des températures de fusion (issue de la littérature) et de début de vaporisation (issues de la littérature ou déterminée par Analyse Thermogravimétrique ATG) :

| Oxydes | Tf (°C) | Tvap (°C) |
|---|---|---|
| ZnO | 1975 | ≈ 1430 |
| $SnO_2$ | 1630 | ≈ 1800-1900 |
| BaO | 1918 | ≈ 2000 |
| CdO | 1500 | ≈ 1000 |
| $In_2O_3$ | 1910 | ≈ 850 |
| $MoO_3$ | 795 | ≈ 1155 |
| Composés | | |
| ITO | 1900 | ≈ 2000 |
| ... | ... | ... |

On peut citer également les composés dérivés des oxydes purs suivants tels que :

- AZO (Oxyde de Zinc dopé Alumine)
- MZO (Oxyde de Zinc - Oxyde de Molybdène)
- GZO (Oxyde de Zinc dopé Gallium)
- ATO (Oxyde d'Etain - Oxyde d'Antimoine)
- FTO (Oxyde d'Etain - Fluor)

Ainsi que les mélanges de ces oxydes comme par exemple l'oxyde mixte d'étain et de zinc
Au sens de l'invention, on entend par métaux réfractaires, les métaux choisis parmi la liste des métaux réfractaires : Tungstène, Tantale, Niobium, Titane, Vanadium, Hafnium, Zirconium, Rhénium, Rhodium
ainsi que les alliages réfractaires définis en ce qu'ils sont constitués d'un alliage AB où :

A et B appartiennent à la liste d'éléments suivante : Mo, W, Ta, Nb, Ti, V, Hf, Zr, Re, Rh

Ainsi qu'aux alliages de type AM où :

A appartient à la liste : Mo, W, Ta, Nb, Ti, V, Hf, Zr, Re

M appartient à la liste : Co, Ni, Rh, Pd, Pt, Cu, Ag, Au

A cet effet, le procédé de réalisation, objet de l'invention, d'une cible par projection thermique, par projection plasma au moyen d'une torche plasma, ladite cible comprenant au moins un composé choisi parmi des métaux réfractaires, ou d'oxydes résistifs, ou d'oxydes volatils, caractérisé en ce qu'on projette par projection thermique sur au moins une portion de surface de la cible, au moins une fraction dudit composé sous forme d'une composition de poudre dudit composé, sous atmosphère contrôlée, et en ce qu'on utilise des jets refroidisseurs cryogéniques puissants dirigés vers la cible pendant sa construction et répartis autour de la torche.

On rappelle que sont par définition considérés comme cryogéniques des fluides dont la température est inférieure ou égale à -150°C.

L'utilisation pendant la projection plasma de jets refroidisseurs cryogéniques (jets de liquide cryogéniques ou jets mixtes gaz/liquide cryogéniques ou jets de gaz cryogéniques) permet d'améliorer la qualité de la cible en assurant une triple fonction :

- un refroidissement immédiat de la zone projetée annihilant par la même toute possibilité de modification chimique pour les composés réfractaires et pour les oxydes résistifs, du matériau projeté,
- un nettoyage puissant de la surface projetée afin d'assurer une excellente cohésion propre entre les particules et les passes successives
- à réduire les contraintes internes tout en augmentant le rendement matière

Par ailleurs, l'utilisation d'une torche plasma et d'un mélange de gaz plasmagène permettent d'obtenir une forte réduction en vol des particules de poudre projetée, réduisant ainsi le taux d'oxygène présent dans la cible comparativement à celui présent dans la poudre ($T_{oc} < T_{op}$ où $T_{oc}$ est le taux d'oxygène présent dans la cible et $T_{op}$ est le taux d'oxygène présent dans la poudre), pour les composés réfractaires ou les composés résistifs.

D'autre part, le procédé objet de l'invention comporte les aspects suivants, plus classiques :

- on réalise un mouvement relatif entre la torche plasma et la cible,
- on réalise une préparation de surface de la cible préalablement au dépôt dudit composé,
- la préparation de surface comporte une étape de jet d'abrasifs (communément appelé sablage) sur la portion de surface de la cible concernée ou alternativement une étape d'usinage de stries adaptées à l'accrochage de la sous-couche,
- la préparation de surface comporte ensuite la projection d'une couche d'un matériau d'accrochage (sous-couche) au niveau de la portion de surface de la cible concernée,

Dans d'autres modes de réalisation de l'invention, on peut éventuellement avoir recours en outre à l'une et/ou à l'autre des dispositions suivantes :

- la projection du composé réfractaire et résistif est réalisée au sein d'une enceinte ayant été purgée ou rincée puis remplie d'un gaz inerte, jusqu'à une pression pouvant aller de 50 mbars à 1100 mbars, de manière à créer en son sein une atmosphère appauvrie en oxygène
- tout ou partie des jets refroidisseurs sont à caractère oxydant.
- on utilise une sous-couche d'accrochage, cette dernière étant déposée avant projection thermique dudit composé au niveau de la portion de surface de la cible concernée.
- on procède à une régulation thermique de la cible lors de la projection plasma.
- on utilise une composition de poudre dudit composé projetée comportant des poudres de granulométrie $5 < D_{10} < 50\ \mu m$ ; $25\ \mu m < D_{50} < 100\ \mu m$ et $40\ \mu m < D_{90} < 200\ \mu m$
- il comporte une étape subséquente de traitement thermique sous atmosphère réductrice visant à réduire le taux d'oxygène présent dans la cible à l'issue de l'étape de projection thermique
- on utilise plusieurs injecteurs dudit composé pour injecter en différents points du jet thermique différents matériaux pour lesquels on ajuste indépendamment les paramètres d'injection en fonction des matériaux injectés dans chaque injecteur.

Dans le cas où la cible comporte un élément d'addition ou un assemblage de plusieurs matériaux, les différents éléments peuvent être apportés par l'un des moyens suivants :

- utilisation d'une poudre pré-alliée dans laquelle chaque grain de poudre est de la composition voulue pour la cible, éventuellement légèrement différente pour tenir compte d'éventuelles pertes inégales par volatilisation lors de la projection thermique de la poudre

- utilisation de 2 ou plusieurs poudres, chacune étant injectées par un canal différent dans le jet thermique lors de l'étape de projection thermique
- la cible est de géométrie plane
- la cible est de géométrie tubulaire.
- la cible comporte des surépaisseurs de matière à chacune de ses extrémités.
- la cible comprend une ou plusieurs pièces sur lesquelles le composé est déposé, ladite ou lesdites pièce(s) est ou sont soit un support plan adaptable sur une machine de pulvérisation soit des pièces intermédiaires liées ensuite sur ce support.
- les surépaisseurs sont de l'ordre de 25 à 50 % de l'épaisseur nominale de la couche de composé.
- la cible présente une densité supérieure à 85 %, préférentiellement supérieure à 90 %,
- l'épaisseur nominale (e) est comprise entre 1 et 25 mm, préférentiellement comprise entre 6 et 14 mm.
- la cible présente une pureté d'au moins 99,5 %.
- la cible est construite sur un matériau support offrant des caractéristiques compatibles avec les propriétés attendues d'une cible magnétron en utilisation (résistance mécanique suffisante, conductivité thermique suffisante, résistance à la corrosion par l'eau de refroidissement en utilisation de la cible, ...), comme par exemple du cuivre ou alliage cuivreux, ou en acier inoxydable austénitique, comme par exemple du X2CrNi18-9 ou du X2CrNiMo17-12-2

A titre d'exemples non limitatifs, l'invention peut être illustrée par les figures suivantes :

- les figures 1a 1b et 1c sont des vues montrant la microstructure en coupe d'une cible Mo obtenue par le procédé d'élaboration selon l'invention,
- les figures 1d et 1e sont des vues illustrant la microstructure en coupe d'une cible de tungstène obtenue par le procédé d'élaboration selon l'invention
- la figure 2 est une vue illustrant microstructure en coupe d'une cible de titanate de baryum (oxyde résistif) obtenue par le procédé d'élaboration selon l'invention
- la figure 3 est une vue illustrant microstructure en coupe d'une cible d'oxyde mixte d'aluminium et de zinc (oxyde volatil) obtenue par le procédé d'élaboration selon l'invention

D'autres caractéristiques et avantages de l'invention apparaîtront au cours de la description qui suit

DESCRIPTION DETAILLEE DE L'INVENTION :

Le support sur lequel sera construite la cible peut être constitué de Cuivre, d'alliage cuivreux, d'acier inoxydable ou autre alliage habituellement compatible avec la réalisation de cibles magnétron. Dans la présente invention, aucune exigence particulière liée au procédé décrit dans l'invention n'est requise concernant le support si ce n'est qu'il devra répondre aux exigences habituelles concernant les cibles magnétron, exigences en termes de géométrie, résistance mécanique, inertie chimique vis-à-vis de l'eau de refroidissement.

Préparation de surface du support

Après avoir été dégraissée, la surface du support est préparée par jet de grains abrasifs. Ces grains peuvent être de nature diverse : grains de Corindon (Alumine blanche fondue), de Corindon Brun, d'Abrasif Alumine-Zircone, d'abrasifs élaborés à partir de scories de fusion (type Vasilgrit), de grenat Almandine, ou encore de grenaille d'acier ou de fonte angulaire (liste non exhaustive).

Préférentiellement, les abrasifs suivants sont utilisés : Corindon (Alumine blanche fondue), Alumine-Zircone (Par exemple AZ 24 de Saint-Gobain Coating Solutions) (ce matériau est préféré pour sa haute ténacité qui limite la fracturation des grains et par voie de conséquence l'inclusion de fractions de grains dans la surface, inclusions néfastes pour l'adhérence du revêtement). Les diamètres moyens des grains d'abrasifs sont préférentiellement compris entre 180 et 800 $\mu$m selon le type d'abrasif. La finalité de cette opération est d'assurer une rugosité de surface apte à assurer une adhérence correcte de la sous-couche de liaison ou du matériau constitutif de la cible

Une méthode alternative consiste à réaliser un usinage de stries qui permettra également une bonne adhérence de la sous-couche puis de la couche fonctionnelle ou du matériau constitutif de la cible

Réalisation d'une sous-couche de liaison par projection thermique

Afin d'optimiser l'adhérence mécanique de la couche fonctionnelle de la cible, une sous-couche de liaison est réalisée par projection thermique. Cette opération peut recourir aux procédés classiques de projection thermique parmi les procédés suivants : projection plasma (de poudre), projection à l'arc électrique (de fils), projection à flamme oxy-gaz (fil ou poudre selon équipements), projection par procédé HVOF (High Velocity Oxy Fuel), procédé de projection par canon à détonation, procédé de projection par gaz éventuellement préchauffé chargé de poudre (Cold spray). Cette opération peut être réalisée à l'air ambiant sans que cela ne nuise à l'invention.

Le matériau de sous-couche de liaison peut être choisi parmi les matériaux classiques utilisés couramment en tant que sous-couche :

- Ni ou alliages base Nickel : NiAl, NiCr, NiCrAl, Fe ou alliages ferreux : FeCrAl, Aciers FeCrC, FeMnC, aciers inoxydable austénitique X2CrNi18-9 ou du X2CrNiMo17-12-2, etc...
- Cu ou alliages Cuivreux tels que CuAl, CuAlFe, CuZn, ....
- Mo ou alliages de Mo : MoCu, etc..

La liste ci-dessus n'est pas exhaustive, le choix du matériau de sous-couche pouvant dépendre du matériau du tube support et de l'équipement de projection (et de la disponibilité du matériau d'apport sous la forme idoine).

<u>Construction de la couche fonctionnelle de la cible objet de l'invention, préférentiellement par projection plasma</u>

La couche fonctionnelle de la cible est construite par projection thermique, préférentiellement par projection plasma (plasma spraying), dans les conditions particulières suivantes : pour 1 et 2

- Projection plasma réalisée dans une enceinte dont l'atmosphère est contrôlée, c'est-à-dire par exemple dont le taux d'oxygène et d'azote est bas, l'atmosphère étant constituée majoritairement de gaz neutre et dont la pression est comprise entre 50 mbars et 1100 mbars
- Projection plasma utilisant un mélange de gaz plasmagènes neutre ou plus ou moins réducteur qui permettra d'abaisser le taux d'oxygène initialement présent en surface des particules de poudre lors de leur fusion et en cours de vol vers le substrat, ce qui est le cas par exemple lorsque le composé est un matériau réfractaire, ou lorsque le composé est un oxyde résistif.
- Utilisation de buses permettant le soufflage de jets puissants, cryogéniques liquides ou gazeux, d'un fluide inerte (cas des métaux réfractaires ou oxydes résistifs) ou d'un fluide inerte ou oxydant (cas des oxydes volatils), les jets étant répârtis autour de la torche
- Mouvements relatifs torche - cible permettant de moduler éventuellement les épaisseurs construites sur la cible et notamment aux extrémités de cette dernière par la réalisation de surépaisseurs communément appelées en anglais « dog-bone »
- Recours à un voire plusieurs injecteurs de poudre permettant une meilleure répartition de la poudre au sein de jet de plasma.
- Torche plasma pouvant être :

  o Une torche plasma soufflé à courant continu disponible sur le marché
  o Une torche plasma RF à couplage induction

La poudre utilisée pour réaliser la cible présente les caractéristiques typiques suivantes
Granulométrie définie telle que :

  o D10% (diamètre tel que 10% des particules sont de taille inférieure à ce diamètre) compris entre 5 et 50 $\mu$m
  o D50% (diamètre médian) compris entre 25 et 100 $\mu$m
  o D90% (diamètre tel que 90% des particules sont de taille inférieure à ce diamètre) compris entre 40 et 200 $\mu$m

- Pureté conforme aux objectifs de pureté de la cible, préférentiellement supérieure à 99,5%
- Taux d'oxygène : < 1500 ppm, préférentiellement < 1000 ppm, voire < 500 ppm, pour les métaux réfractaires

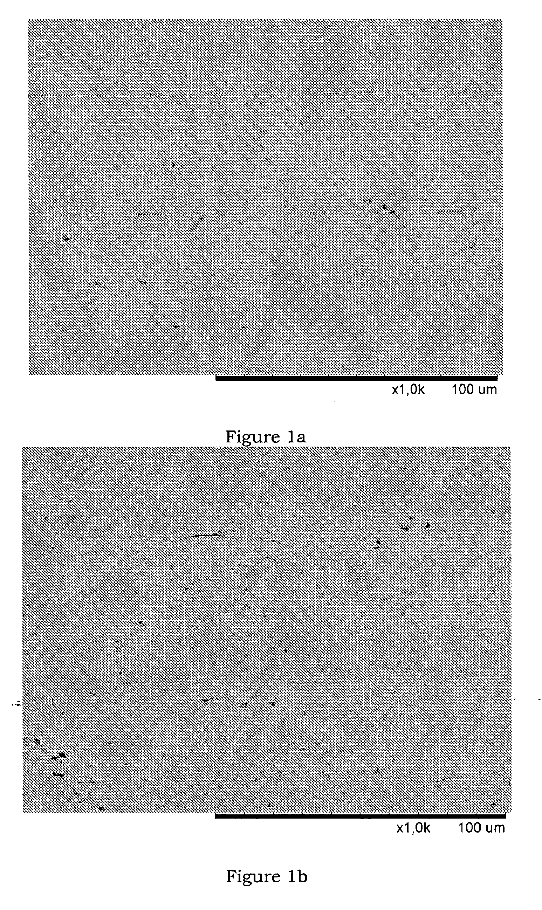

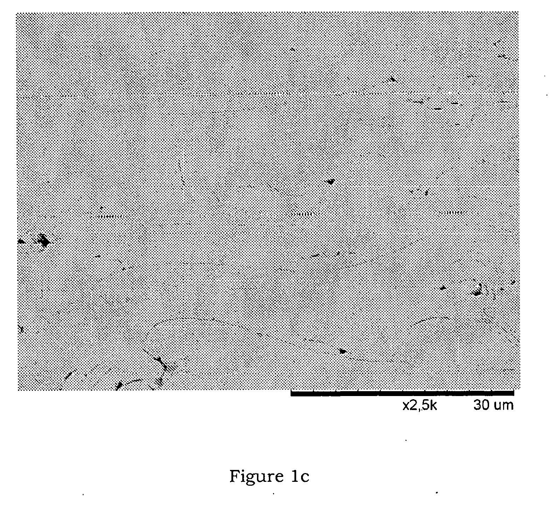

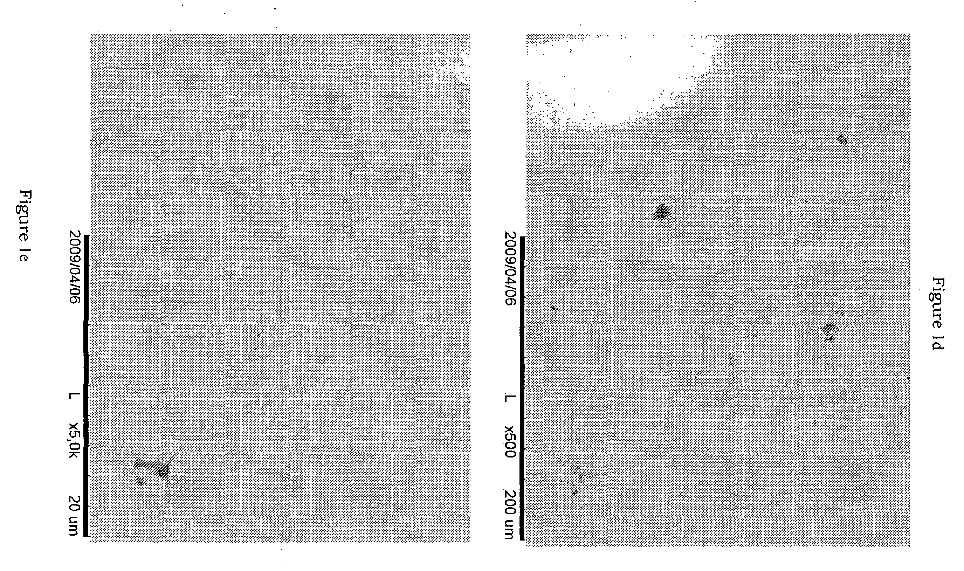

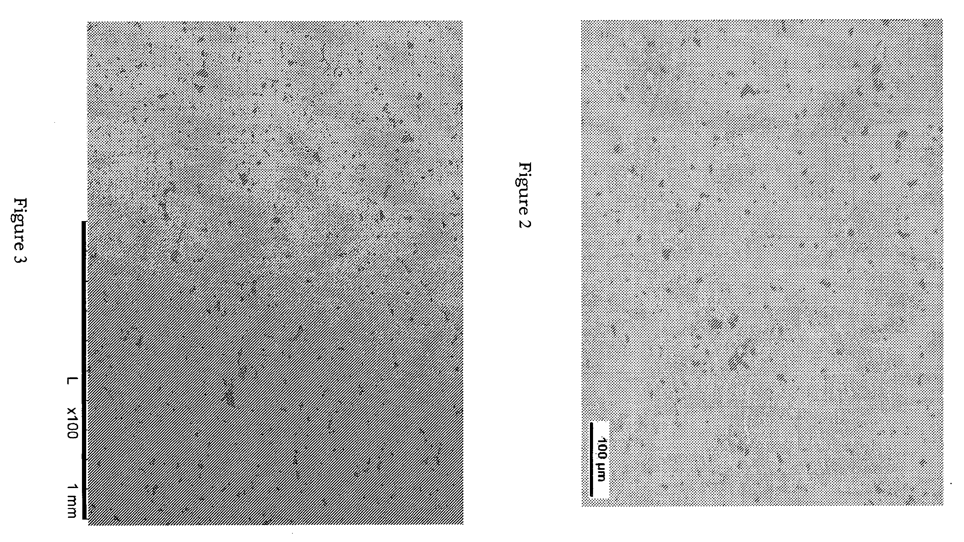

Le procédé objet de l'invention permet l'obtention d'une qualité de cible supérieure à celle obtenue classiquement par projection et qui présente une microstructure lamellaire : on pourra se reporter aux figures 1a, 1b, 1c pour le molybdène ; aux figures 1d, 1e pour le tungstène, à la figure 2 pour l'oxyde résistif, et à la figure 3 pour l'oxyde volatil

- obtention d'une cible en métal réfractaire ayant un taux d'oxygène inférieur à 500 ppm directement, sans étape subséquente telle qu'un traitement thermique sous atmosphère réductrice à haute température.

Le fait de ne pas utiliser d'étape ultérieure de traitement thermique offre l'avantage d'utiliser tout type de matériau support (tube pour cible tubulaire ou support plan pour cibles planes) y compris les supports ayant un coefficient de dilatation nettement différent du matériau constitutif de la cible (métal réfractaire ou oxyde résistif), tels que les aciers inoxydables austénitiques, ce qui serait proscrit dans le cas d'un traitement thermique subséquent visant à réduire le taux d'oxygène.

Bien entendu, un traitement thermique peut également être réalisé de manière optionnelle afin de réduire encore le taux d'oxygène dans la cible ainsi réalisée.

Cas de cibles planes :

La présente invention permet de réaliser des cibles planes selon la procédure suivante :

- Support de cible plan, adapté au montage pour l'utilisation dans le magnétron
- Dans le cas où le support de cible est de forme complexe et doit être recyclable après usage de la cible, la construction du matériau cible ne sera pas réalisée directement sur le support de cible mais sur une ou plusieurs plaques intermédiaires (appelées « tuiles ») lesquelles seront brasées sur le support.
- La construction du matériau cible (par exemple à base de molybdène) sur le support ou sur la ou les tuile(s) sera réalisée en suivant le même procédé que ci-dessus.
- La liaison de la ou des tuile(s) pourra être effectuée avant construction du matériau cible (si la rigidité mécanique du support est importante) ou après construction du matériau cible sur les tuiles dans le cas où le support n'offre pas une rigidité suffisante. Dans ce dernier cas, les dimensions des tuiles seront déterminées de manière à minimiser les risques de déformation de celles-ci lors de l'opération de construction du matériau cible par projection plasma.

## **EXEMPLES DE REALISATION :**

Cet exemple 1 (figures 1a, 1b, 1c) de réalisation concerne une cible tubulaire à base d'un métal réfractaire, notamment à base de molybdène, destinée à être utilisée en pulvérisation magnétron à cathode rotative. Le procédé suivant a été mis en oeuvre :

- Tube support en acier inox austénitique comme par exemple du X2CrNi18-9 ou du X2CrNiMo17-12-2
- Préparation de surface du tube support par projection d'abrasif Alumine-Zircone AZ grit 24
- Réalisation de la sous-couche d'accrochage par le procédé Arc Electrique (Twin Arc wire spraying), réalisé sous air, sous-couche d'accrochage de composition NiAl (95% Nickel - 5% Aluminium). Dans l'exemple décrit, l'épaisseur de la sous-couche d'accrochage est de 200 $\mu$m nominal.
- Elaboration de la couche active de molybdène sur la cible par projection plasma dans les conditions suivantes :
o Torche plasma conférant des caractéristiques particulières de vitesse de jet de plasma et par conséquent de particules projetées
○ Cible disposée dans une enceinte .
○ Création d'une atmosphère inerte dans l'enceinte par exemple par pompage puis remplissage
o Utilisation de jets refroidisseurs cryogéniques dirigés vers la cible et répartis autour de la torche
o La poudre utilisée pour la réalisation de la cible est une poudre de Molybdène présentant les caractéristiques suivantes :

- ■ Poudre de type agglomérée-frittée de Molybdène
- ■ Granulométrie $d_{50}$ = 80 $\mu$m
- ■ Pureté 99.95% avec notamment : 20 ppm de Fe et 600 ppm d'Oxygène

o Projection plasma menée avec les paramètres suivants :
■ Une torche plasma avec les paramètres suivants ont été utilisés pour la réalisation de la cible de l'exemple :

| Paramètres | Débit Ar (slpm) | Débit $H_2$ (slpm) | Intensité d'arc (A) | Distance projection (mm) | Débit poudre (gr/min) |
|---|---|---|---|---|---|
| Valeurs utilisées | 50 | 15 | 600 | 160 | 160 |

o Finition de surface par polissage ou usinage pour obtention d'une rugosité telle que $R_{max}$< 15 $\mu$m

Comme indiqué précédemment, grâce au procédé spécifique objet de la présente invention, le taux d'oxygène dans la cible obtenue est de 450 ppm, inférieur au taux de 600 ppm initialement présent dans la poudre.

Des résultats complémentaires selon ce protocole de réalisation d'une cible en molybdène, avec des compositions différents de poudre et comparés à un résultat sans jet cryogénique selon l'invention sont présentés dans le tableau ci-dessous

| Ref Essai | Procédé | Taux d'O dans la poudre | Taux de N dans la poudre | Taux d'O dans la Cible | Taux de N dans la cible |
|---|---|---|---|---|---|
| A | Selon invention | 657 | 18 | 340 | 20 |
| B | Selon invention | 657 | 18 | 240 | 20 |
| C | Selon invention | 922 | 26 | 340 | 23 |
| D | Selon invention | 526 | 29 | 360 | 18 |
| E | Selon invention | 526 | 29 | 360 | 19 |
| F | Selon invention | 706 | 31 | 580 | 30 |
| G | Sans jets refroidisseurs | 560 | 29 | 960 | 83 |

Comme le montrent les résultats, le procédé de pulvérisation plasma avec jets refroidisseurs cryogéniques répartis autour de la torche plasma permet de réduire le taux d'oxygène dans la cible par rapport au taux d'oxygène dans la poudre de départ. Il est ainsi inutile de choisir une poudre de départ très pure, d'autant plus qu'il n'est possible, dans la pratique, d'éviter que la poudre ne contienne une certaine quantité d'oxygène. Le procédé selon l'invention est ainsi particulièrement avantageux.

On donne ci-après un exemple 2 de réalisation d'une cible à base d'un composé réfractaire. Il s'agit ici du tungstène (se reporter aux figures 1d, 1e)

L'exemple de réalisation concerne une cible plane en Tungstène destinée à être utilisée en pulvérisation magnétron en mode DC (courant continu).

Le procédé suivant a été mis en oeuvre :

- Construction de la cible sur plaque support intermédiaire en Cuivre, destinée à être brasée ensuite sur le support de cible
- Préparation de surface de la plaque support par projection d'abrasif Alumine-Zircone AZ grit 36
- Réalisation de la sous-couche d'accrochage par projection plasma d'un alliage CuAl (90/10), sous-couche d'épaisseur 150 $\mu$m.
- Elaboration de la couche active de tungstène sur la cible par projection plasma dans les conditions suivantes :

○ Torche plasma conférant des caractéristiques particulières de vitesse de jet de plasma et par conséquent de particules projetées

○ Cible disposée dans une enceinte

○ Cycle de pompage (jusqu'à obtention d'un vide de $5.10^{-2}$ kPa) suivi d'un remplissage d'Argon de l'enceinte (jusqu'à 1 atm) de manière à obtenir une atmosphère inerte (composée d'Argon avec pression partielle d'oxygène $< 1.10^{-2}$ kPa) dans l'enceinte

○ Utilisation de jets refroidisseurs cryogéniques dirigés vers la cible et répartis autour de la torche

○ La poudre utilisée pour la réalisation de la cible est une poudre de Tungstène présentant les caractéristiques suivantes :

■ Granulométrie $d_{50} = 25$ $\mu$m
■ Pureté 99.95%

○ Projection plasma menée avec les paramètres suivants :

■ Une torche plasma avec les paramètres suivants ont été utilisés pour la réalisation de la cible de l'exemple :

| Paramètres | Débit Ar (slpm) | Débit H$_2$ (slpm) | Intensité d'arc (A) | Distance projection (mm) | Débit poudre (gr/min) |
|---|---|---|---|---|---|
| Valeurs utilisées | 60 | 14 | 550 | 130 | 120 |

○ Finition de surface par polissage ou usinage pour obtention d'une rugosité telle que $R_{max} < 15$ $\mu$m

La cible obtenue présente les autres caractéristiques remarquables suivantes :

Densité = 88%

Résistivité électrique :

| | |
|---|---|
| Résistivité volumique théorique de W à 20°C | 5.5 $\mu\Omega$.cm |
| Résistivité volumique mesurée sur la cible par la méthode ASTM F76 (Van der Pauw) à 20°C | 9.55 $\mu\Omega$.cm |

Exemple 3 de réalisation d'une cible magnétron en Oxyde résistif (se reporter à la figure 2)

L'exemple de réalisation concerne une cible, plane, en Titanate de Baryum BaTiO$_{3-x}$ destinée à être utilisée en pulvérisation magnétron en mode DC (courant continu).

Le procédé suivant a été mis en oeuvre :
- Construction de la cible sur plaque support intermédiaire en Cuivre, destinée à être brasée ensuite sur le support de cible
- Préparation de surface de la plaque support par projection d'abrasif Alumine-Zircone AZ grit 36
- Réalisation de la sous-couche d'accrochage par projection plasma d'un alliage CuAl (90/10), sous-couche d'épaisseur 150 $\mu$m.
- Elaboration de la couche active de BaTiO$_{3-x}$ sur la cible par projection plasma dans les conditions suivantes :
o Torche plasma conférant des caractéristiques particulières de vitesse de jet de plasma et par conséquent de particules projetées
○ Cible disposée dans une enceinte .
○ Cycle de pompage (jusqu'à obtention d'un vide de 5.10$^{-2}$ kPa) suivi d'un remplissage d'Argon de l'enceinte (jusqu'à 1 atm) de manière à obtenir une atmosphère inerte (composée d'Argon avec pression partielle d'oxygène < 1.10$^{-2}$ kPa) dans l'enceinte
o Utilisation de jets refroidisseurs cryogéniques dirigés vers la cible et répartis autour de la torche
o La poudre utilisée pour la réalisation de la cible est une poudre de Titanate de Baryum présentant les caractéristiques suivantes :

■ Poudre de type agglomérée
■ Granulométrie d$_{50}$ = 70 $\mu$m
■ Pureté 99.5 % (impureté SrO exclue)

o Projection plasma menée avec les paramètres suivants :
■ Une torche plasma avec les paramètres suivants ont été utilisés pour la réalisation de la cible de l'exemple :

| Paramètres | Débit Ar (slpm) | Débit H$_2$ (slpm) | Intensité d'arc (A) | Distance projection (mm) | Débit poudre (gr/min) |
|---|---|---|---|---|---|
| Valeurs utilisées | 35 | 15 | 500 | 120 | 35 |

o Finition de surface par polissage ou usinage pour obtention d'une rugosité telle que R$_{max}$< 15 $\mu$m

Caractéristique essentielle et avantage de la cible ainsi produite :

| | |
|---|---|
| Résistivité volumique théorique de BaTiO$_3$ | 10$^9$ $\Omega$.cm |
| Résistivité volumique mesurée sur la cible à 20°C | 4.5 k$\Omega$.cm |

Le procédé objet de l'invention permet une réduction très forte de la résistivité du matériau de la cible via la création de lacunes d'oxygène.
De ce fait, la cible objet de l'exemple a pu être utilisée en mode magnétron DC, et a permis de réaliser des couches de BaTiO$_3$ stoechiométrique par utilisation d'une pression partielle modérée en magnétron (ne produisant pas les mêmes inconvénients qu'en magnétron réactifs avec forte valeur de pression partielle, par exemple les phénomènes d'hystérésis en pO$_2$)

Exemple 4 : Exemple de réalisation de cible magnétron en Oxyde Volatil (se reporter à la figure 3)

L'exemple de réalisation concerne une cible tubulaire destinée à être utilisée en pulvérisation magnétron à cathode rotative. Le procédé suivant a été mis en oeuvre :
- Tube support en acier inox austénitique comme par exemple du X2CrNi18-9 ou du X2CrNiMo17-12-2
- Préparation de surface du tube support par projection d'abrasif Alumine-Zircone AZ grit 24
- Réalisation de la sous-couche d'accrochage par le procédé Plasma Spray (projection plasma), réalisé sous air, sous-couche d'accrochage de composition NiAl (80% Nickel - 20% Aluminium). Dans l'exemple décrit, l'épaisseur de la sous-couche d'accrochage est de 150 $\mu$m nominal.
- Elaboration de la couche active de AZO ($ZnO$-2% $Al_2O_3$) sur la cible par projection plasma dans les conditions suivantes :
  o Torche plasma conférant des caractéristiques particulières de vitesse de jet de plasma et par conséquent de particules projetées
  o Cible disposée dans une enceinte
  ○ Utilisation de jets refroidisseurs
  o La poudre utilisée pour la réalisation de la cible est une poudre d'AZO présentant les caractéristiques suivantes :

  ■ Granulométrie $d_{50}$ = 50 $\mu$m
  ■ Pureté 99.9%

  o Projection plasma menée avec les paramètres suivants :
  ■ Une torche plasma avec les paramètres suivants ont été utilisés pour la réalisation de la cible de l'exemple :

| Paramètres | Débit Ar (slpm) | Débit $H_2$ (slpm) | Intensité d'arc (A) | Distance projection (mm) | Débit poudre (gr/min) |
|---|---|---|---|---|---|
| Valeurs utilisées | 45 | 15 | 700 | 70-110 | 45 |

  o Finition de surface par polissage ou usinage pour obtention d'une rugosité telle que $R_{max}$ < 15 $\mu$m
  Le procédé objet de l'invention a permis de réaliser une cible d'AZO d'épaisseur 6 mm, sans fissuration, et monolithique, sans joints entre segments.
  La cible obtenue présentait une densité de 92% (5,15 gr/cm$^3$ pour une densité théorique de AZO de 5.57)

PROPRIETES ET AVANTAGES DE L'INVENTION

- Les cibles objet de la présente invention présentent les propriétés et avantages suivants :

  o meilleur taux d'utilisation de la matière des cibles tubulaires obtenues par torche plasma par rapport à celles obtenues par les procédés de frittage (et/ou formage à chaud) du fait que le procédé objet de la présente invention offre la possibilité de déposer une surépaisseur en extrémité de cibles pour compenser la sur-érosion localisée dans les zones correspondant aux virages à faible rayon de courbure du champ magnétique créé par les cathodes et leurs aimants. Ceci permet d'atteindre des rendements matière de cibles supérieurs à 75%, voir 80% alors que les rendements restent inférieurs à 75% sur des cibles à profil plat. Corolairement du fait de l'utilisation de ce type de cible, notamment dans le cas particulier du Molybdène pur, on obtient des couches, dont le profil d'homogénéité de la Rcarré selon une dimension caractéristique du substrat à la surface duquel la couche est déposée ne dévie pas plus de +/- 2 % (par exemple sur un substrat de largeur de 3,20 m). Cette mesure est réalisée à l'aide d'un appareil de type « nagy » par mesure sans contact.
  ○ Large gamme d'épaisseur de matériau sur la cible entre 1 et 25mm : on peut choisir l'épaisseur de la cible en fonction de la durée vie souhaitée de celle-ci (cette épaisseur étant en fait déterminée par la durée de production escomptée sans arrêt de ligne)
  o dans le cas de cibles tubulaires, il est possible de polariser la cible en mode en AC (alternative current) ou DC (direct current) avec des puissances supérieures à 30 kW/m (gain en vitesse de dépôt), sans risque de fissuration par gradient thermique entre le tube support et la cible) ou de fusion de brasure.
  ○ du fait de l'épaisseur de matériau réduite à la valeur strictement nécessaire pour l'utilisateur, il est possible de limiter la tension nécessaire à soutenir la décharge à haute puissance et de rendre ainsi cette cible compatible avec les alimentations électriques magnétron courantes.

Dans le cas des cibles à base d'oxyde résistif selon l'invention, les avantages sont les suivants

- possibilité de réaliser des cibles céramiques permettant l'obtention de couches minces résistives par pulvérisation magnétron non-réactive, nécessitant l'utilisation de pression partielle d'oxygène modérée (pas d'effet d'hystérésis en utilisation). Les cibles céramiques obtenues par le procédé objet de l'invention présentent une résistivité fortement réduite par rapport à la résistivité théorique du composé
- possibilité de réaliser des cibles cylindriques de grandes dimensions monolithiques
- possibilité sur ces cibles de réaliser des surépaisseurs locales aux extrémités (« Dog-Bones »)
- excellente liaison au tube support sans phase intermédiaire fusible

Dans le cas des cibles à base d'oxyde volatil selon l'invention, elles offrent les avantages suivants :

- minimiser les pertes liées au rendement matière et de rendre le procédé viable pour ce type de composition
- réduire les contraintes internes dans les cibles élaborées par le procédé en question, sans nécessité d'augmenter la porosité, ce qui permet de construire des cibles ayant des épaisseurs plus importantes que l'état de l'art par projection plasma (par exemple 6 mm pour AZO).

Dans le cas de cibles tubulaires ou planes monolithiques réalisées grâce à la présente invention, et par contraste avec les cibles comportant des segments assemblés, les risques suivants sont considérablement réduits :

o risque d'apparition de phénomène d'arcing qui génère des particules parasites, ainsi que le risque de désolidarisation de fragments du matériau cible de son support, qui est connu pour être une source de pollution des couches en molybdène.
○ risque de pulvérisation du matériau de brasure ou du matériau du support de cible via les interstices entre segments.
○ risque de défaillance thermique ou mécanique de la liaison (brasure ou colle conductrice) sur le support.

## Revendications

1. Procédé de réalisation d'une cible par projection thermique, par projection plasma au moyen d'une torche plasma, ladite cible comprenant au moins un composé choisi par les métaux réfractaires, les oxydes résistifs, les oxydes volatils **caractérisé en ce qu'**on projette par projection thermique sur au moins une portion de surface de la cible, au moins une fraction dudit composé sous forme d'une composition de poudre dudit composé, sous atmosphère contrôlée, et **en ce qu'**on utilise des jets refroidisseurs cryogéniques puissants dirigés vers la cible pendant sa construction et répartis autour de la torche plasma.

2. Procédé de réalisation selon la revendication 1, **caractérisé en ce que** la projection du composé est réalisée au sein d'une enceinte ayant été purgée ou rincée puis remplie du gaz inerte, jusqu'à une pression pouvant aller de 50 mbars à 1100 mbars, de manière à créer en son sein une atmosphère appauvrie en oxygène..

3. Procédé de réalisation selon l'une des revendications 1 ou 2, **caractérisé en ce que** la projection thermique est réalisée par une torche plasma et **en ce que** le mélange de gaz plasmagène utilisé est réducteur (apte à réduire le taux de composé oxydé initialement présent dans la poudre), préférentiellement la composition du mélange plasmagène comportant plus de 10% d'Hydrogène ou un autre gaz plasmagène réducteur.

4. Procédé de réalisation selon la revendication 1 **caractérisé en ce que** tout ou partie des jets refroidisseurs sont à caractère oxydant.

5. Procédé de réalisation selon l'une quelconque des revendications précédentes, **caractérisé en ce qu'**on utilise une sous couche d'accrochage, cette dernière étant déposée avant projection thermique dudit composé au niveau de la portion de surface de la cible concernée.

6. Procédé de réalisation selon l'une quelconque des revendications précédentes, **caractérisé en ce qu'**on procède à une régulation thermique de la cible lors de la projection plasma.

7. Procédé de réalisation selon l'une quelconque des revendications précédentes, **caractérisé en ce qu'**on utilise une composition de poudre dudit composé projetée comportant des poudres de granulométrie 5 < $D_{10}$ <50 $\mu$m ; 25 $\mu$m < $D_{50}$ < 100 $\mu$m, et 40 $\mu$m < $D_{90}$ < 200 $\mu$m

8.  Procédé de réalisation selon l'une quelconque des revendications 1 à 3 et 5 à 7, **caractérisé en ce qu'**il comporte une étape subséquente de traitement thermique sous atmosphère réductrice visant à réduire le taux d'oxygène présent dans la cible à l'issue de l'étape de projection thermique.

9.  Procédé de réalisation selon l'une quelconque des revendications précédentes, **caractérisé en ce qu'**on utilise plusieurs injecteurs dudit composé pour injecter en différents points du jet thermique différents matériaux pour lesquels on ajuste indépendamment les paramètres d'injection en fonction des matériaux injectés dans chaque injecteur.

**Patentansprüche**

1.  Verfahren zur Herstellung eines Targets durch thermisches Spritzen, durch Plasmaspritzen mittels einer Plasmafackel, wobei das Target wenigstens eine Verbindung, ausgewählt aus den hochschmelzenden Metallen, den resistiven Oxiden, den flüchtigen Oxiden umfasst, **dadurch gekennzeichnet, dass** auf wenigstens einen Flächenabschnitt des Targets wenigstens ein Teil der Verbindung in Form einer Pulverzusammensetzung der Verbindung unter kontrollierter Atmosphäre durch thermisches Spritzen aufgespritzt wird und dass starke kryogene Kühlstrahlen, die während seiner Ausbildung auf das Target gerichtet und um die Plasmafackel herum verteilt sind, verwendet werden.

2.  Herstellungsverfahren nach Anspruch 1, **dadurch gekennzeichnet, dass** das Aufspritzen der Verbindung innerhalb eines Raums vollzogen wird, der entleert oder gespült, anschließend mit dem Inertgas gefüllt worden ist, bis zu einem Druck, der von 50 mbar bis 1100 mbar reichen kann, um in seinem Inneren eine sauerstoffverarmte Atmosphäre zu erzeugen.

3.  Herstellungsverfahren nach einem der Ansprüche 1 oder 2, **dadurch gekennzeichnet, dass** das thermische Spritzen durch eine Plasmafackel vollzogen wird und dass das verwendete Plasmagasgemisch reduzierend ist (geeignet, den Anteil von anfangs in dem Pulver vorhandener oxidierter Verbindung zu reduzieren), wobei vorzugsweise die Zusammensetzung des Plasmagemischs mehr als 10 % Wasserstoff oder ein anderes reduzierendes Plasmagas umfasst.

4.  Herstellungsverfahren nach Anspruch 1, **dadurch gekennzeichnet, dass** alle oder ein Teil der Kühlstrahlen oxidierender Art sind.

5.  Herstellungsverfahren nach einem der vorstehenden Ansprüche, **dadurch gekennzeichnet, dass** eine Haftgrundschicht verwendet wird, wobei letztere vor dem thermischen Spritzen der Verbindung im Bereich des betroffenen Flächenabschnitts des Targets abgeschieden wird.

6.  Herstellungsverfahren nach einem der vorstehenden Ansprüche, **dadurch gekennzeichnet, dass** eine Wärmeregelung des Targets während des Plasmaspritzens vorgenommen wird.

7.  Herstellungsverfahren nach einem der vorstehenden Ansprüche, **dadurch gekennzeichnet, dass** eine aufgespritzte Pulverzusammensetzung der Verbindung verwendet wird, die Pulver mit einer Korngröße 5 < $D_{10}$ < 50 $\mu$m; 25 $\mu$m < $D_{50}$ < 100 $\mu$m und 40 $\mu$m < $D_{90}$ < 200 $\mu$m umfasst.

8.  Herstellungsverfahren nach einem der Ansprüche 1 bis 3 und 5 bis 7, **dadurch gekennzeichnet, dass** es einen nachfolgenden Schritt zur Wärmebehandlung unter reduzierender Atmosphäre umfasst, der darauf abzielt, den in dem Target am Ende des Schrittes des thermischen Spritzens vorhandenen Sauerstoffanteil zu reduzieren.

9.  Herstellungsverfahren nach einem der vorstehenden Ansprüche, **dadurch gekennzeichnet, dass** mehrere Spritzdüsen für die Verbindung verwendet werden, um an unterschiedlichen Stellen des Wärmestrahls unterschiedliche Materialien einzuspritzen, für die die Einspritzparameter in Abhängigkeit der in jeder Spritzdüse eingespritzten Materialien unabhängig eingestellt werden.

**Claims**

1. Process for producing a target by thermal spraying, by plasma spraying by means of a plasma torch, said target comprising at least one compound chosen from refractory metals, resistive oxides and volatile oxides, **characterized in that** at least one fraction of said compound in the form of a powder composition of said compound is sprayed by thermal spraying, onto at least one surface portion of the target, in a controlled atmosphere and **in that** powerful cryogenic cooling jets directed onto the target during its construction and distributed around the plasma torch are used.

2. Production process according to Claim 1, **characterized in that** the compound is sprayed in a chamber that has been purged or rinsed and then filled with inert gas, at a pressure that may range from 50 mbar to 1100 mbar, so as to create an oxygen-depleted atmosphere within it.

3. Production process according to either of Claims 1 or 2, **characterized in that** the thermal spraying is carried out by a plasma torch and **in that** the plasma gas mixture used is reducing (capable of reducing the oxidized compound content initially present in the powder), preferably the composition of the plasma gas mixture comprising more than 10% hydrogen or another reducing plasma gas.

4. Production process according to Claim 1, **characterized in that** all or some of the cooling jets have an oxidizing character.

5. Production process according to any one of the preceding claims, **characterized in that** a keying sublayer is used, this being deposited before said compound is thermally sprayed on the surface portion of the target in question.

6. Production process according to any one of the preceding claims, **characterized in that** the target is thermally regulated during the plasma spraying.

7. Production process according to any one of the preceding claims, **characterized in that** a powder composition of said sprayed compound comprising powder particles with a size distribution given by $5 < D_{10} < 50\ \mu m$; $25\ \mu m < D_{50} < 100\ \mu m$; and $40\ \mu m < D_{90} < 200\ \mu m$ is used.

8. Production process according to any one of Claims 1 to 3 and 5 to 7, **characterized in that** it includes a subsequent heat treatment step in a reducing atmosphere for the purpose of reducing the oxygen content present in the target after the thermal spraying step.

9. Production process according to any one of the preceding claims, **characterized in that** several compound injectors are used for injecting, at different points in the thermal jet, different materials for which the injection parameters are adjusted independently according to the materials injected into each injector.

x1,0k    100 um

Figure 1a

x1,0k    100 um

Figure 1b

x2,5k     30 um

Figure 1c

Figure 1d

2009/04/06          L    x500      200 um

2009/04/06          L    x5,0k      20 um

Figure 1e

Figure 2

Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4356073 A
- EP 1784518 A
- US 20080193798 A
- WO 2006041730 A
- WO 20061171451 A
- EP 1712962 A
- JP 701433 A
- JP 7026373 B
- US 20070137999 A